# EUROPEAN PATENT SPECIFICATION

(11) **EP 0 252 757 B1**
(45) Date of publication and mention of the grant of the patent: **08.10.1997**
(21) Application number: 87306129.5
(22) Date of filing: 10.07.1987
(51) Int. Cl.: H01L 27/14, H01L 27/146

(54) **Photoelectric conversion device**
Photoelektrischer Wandler
Dispositif de conversion photo-électrique

(30) Priority: 11.07.1986 JP 162129/86
(43) Date of publication of application: 13.01.1988
(73) Proprietor: CANON KABUSHIKI KAISHA, Tokyo (JP)
(72) Inventor: Ozaki, Masaharu, Yokohama-shi Kanagawa-ken (JP); Yonehara, Takao, Atsugi-shi Kanagawa-ken (JP)
(74) Representative: Beresford, Keith Denis Lewis

(56) References cited:
- EP-A- 0 020 135
- EP-A- 0 244 081
- GB-A- 2 113 465
- GB-A- 2 116 067
- PATENT ABSTRACTS OF JAPAN, vol. 10, no. 16 (E-375)[2073], 22nd January 1986; & JP-A-60 178 662
- TRANSDUCERS '85, 1985 INTERNATIONAL CONFERENCE ON SOLID-STATE SENSORS AND ACTUATORS DIGEST OF TECHNICAL PAPERS, pages 440-442, IEEE; S. Kataoka: "An attempt towords an artificial retina:3-D IC technology for an intelligent image sensor"
- JOURNAL OF THE ELECTROCHEMICAL SOCIETY, vol. 128, no. 6, June 1981, pages 1353- 1359, Princeton, New Jersey, US; W.A.P. CLAASSEN et al.: "The nucleation of CVD silicon on SiO2 and Si3N4 substrates"
- BRITISH JOURNAL OF APPLIED PHYSICS, vol. 18, no. 10, 1967, pages 1357-1382

## Description

The present invention relates to a method of producing a photoelectric conversion device, particularly one of multilayer structure.

Current research and development of three-dimensional integrated circuits is directed to achieving high integration and multi-functions by laying semiconductor elements one above another.

To fabricate a three-dimensional integrated circuit, it is necessary to form on an amorphous insulator a semiconductor thin film in which electronic elements such as transistors are formed. However, in general, in the case of silicon semiconductor, only amorphous silicon or polysilicon can be grown on an amorphous material.

Therefore, amorphous silicon or polysilicon have been used heretofore as a semiconductor layer for electronic elements, or alternatively monocrystalline silicon has been used which is formed by melting and monocrystallizing grown amorphous silicon or polysilicon with a laser beam.

Use of amorphous silicon or polysilicon as a semiconductor layer for electronic elements, however, results in a low electron mobility: lower than 0.1 cm²/V sec for amorphous silicon and 1 to 10 cm²/V sec for polysilicon having a grain diameter of several tens nm (hundreds Angstroms). In addition, a large leakage current flows through a PN junction formed in such material. Thus, electronic elements having a good performance cannot be realised.

Apart from the above, if the monocrystalline silicon layer used as semiconductor layer is produced by melting and monocrystallizing amorphous silicon or polysilicon, although electronic elements of good performance can be realised, heating and melting with a laser beam can influence greatly the performance of elements previously formed beneath this semiconductor layer.

Notably, a 3-D IC photoelectric conversion device, an image sensor, is described in the following article entitled "An attempt towards an artificial retina: 3-D IC technology for an intelligent image sensor" by Kataoka, S., Transducers '85, 1985 International Conference on Solid State Sensors and Actuators, Digest of Technical Papers, IEEE 1985, pages 440-442. As described, a 1st layer incorporating IC elements is produced by conventional means and an insulating layer of SiO₂ is deposited. On this insulating layer a polysilicon film is deposited by chemical vapour deposition and is then converted to single crystal silicon film by surface annealing using a fast scanning laser or electron beam. Only the deposited Si film is heated so as to avoid damage to the IC elements in the 1st layer. Shallow p-n junction photodiodes are then produced in the single-crystal silicon film. It is suggested that with 3 to 5 active layers it would be possible to produce a multi-functional 3-D image sensor.

The present invention is intended as a solution to the above problems.

A method of producing a multi-layer photoelectric conversion device in accordance with the present invention is defined in claim 1 of the claims appended.

In this method the size of each nucleus forming region is limited so that a single nucleus shall be formed thereon during deposition and each islet of single crystal material is grown from a respective one of these single nuclei.

Earlier attempts to grow single crystal silicon by allowing only a single nucleus to grow or by limiting nucleation to a single nucleus proved difficult - British Journal of Applied Physics, vol.18, No.10, 1967, pages 1357-1382, as specifically stated at page 1379 thereof. After nearly two decades, these difficulties have been overcome as reported herein and as reported in European Patent Application EP-A-0244081, which is cited here as prior art under Art. 54(3) EPC. Relevant matter disclosed therein is reproduced in the description given below.

In the preferred embodiment silicon oxide SiO₂ is used as insulator layer material and silicon nitride Si₃N₄ is used for the nucleus forming regions.

It is mentioned that nucleation densities of silicon on SiO₂ and of silicon on Si₃N₄ are discussed and compared in the following article entitled "The nucleation of CVD silicon on SiO₂ and Si₃N₄ substrate" by Claassen, W.A.P. & Bloem, J., Journal of the Electrochemical Society, vol. 128, No.6, June 1981, pages 1353-1359.

In the accompanying drawings:
Fig. 1 is a graph for illustration of the relationship between the size of nucleus r_{c} and free energy G in the process of forming thin film;
Figs. 2A and 2B are illustrations of a selective deposition method;
Fig. 3 is a graph showing the change with lapse of time of nucleation density (ND) on a deposition surface of SiO₂ and a deposition surface of silicon nitride;
Figs. 4A to 4D are illustrations of formation steps of a method for forming single crystal islets;
Figs. 5A and 5B are perspective views of the substrate in Figs. 4A and 4D;
Fig. 6 is a graph showing the relationship between the flow rate of SiH₄ and NH₃ and the composition ratio of Si and N in silicon nitride films;
Fig. 7 is a graph showing the relationship between Si/N composition ratio and nucleation density;
Fig. 8 is a graph showing the relationship between the injected amount of Si ions and nucleation density;
Fig. 9 is a sectional view showing an embodiment of the photoelectric conversion device according to the present invention; and
Fig. 10 is a circuit diagram typical of this embodiment.

For better understanding of the present invention, first the general process for forming a thin film of metal will be explained.

When the deposition surface is made of a material different in kind from the deposited material, particularly an amorphous material, the flying atoms of the deposited material are diffused freely on the substrate surface, or again evaporated (released). And, as the result of collision mutually between the atoms, a nucleus is formed and once its size has reached a size r_{c} (= -2 σo/gv) at which its free energy G is a maximum (critical nucleus), G then reduces and the nucleus continues to grow stably three-dimensionally. A nucleus with a size exceeding r_{c} is called a stable nucleus, and unless otherwise particularly noted, "nucleus" in the following basic description of the present invention refers to this "stable nucleus". Also, among "stable nucleus", those with small r are called "initial nucleus".

The free energy generated by formation of a nucleus is represented as follows:${\text{G = 4 πf(θ) (σo r}}^{\text{2}} {\text{+1/3.gv.r}}^{\text{3}} \text{)} {\text{f(θ) = 1/4(2 - 3cosθ + cos}}^{\text{2}} \text{θ)}$ wherein,
r: radius curvature of nucleus
θ: contact angle of nucleus
gv: free energy per unit deposition
σo: surface energy between nucleus and vacuum.

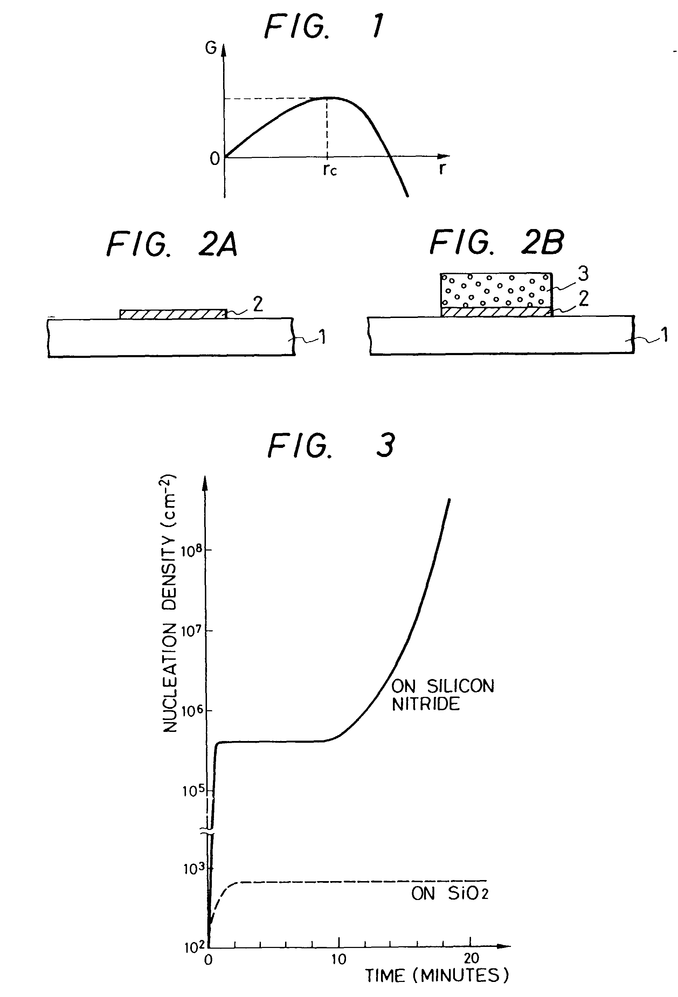

Fig. 1 shows the manner in which G is changed. In this figure, the radius of curvature of the stable nucleus when G is at the maximum value is r_{c}.

Thus, nuclei grow to become island shaped, and further grow whereby mutual contact between islands results in a continuous film completely covering the substrate surface. By such a process, a thin film is deposited on the substrate.

In the deposition process as described above, the density of nuclei formed per unit area of the substrate surface, the size of each nucleus and the nucleation speed are determined depending on the state of the system of deposition. In particular,the interaction between the flying atoms and the substrate surface material is an important factor. Also, a specific crystal direction grows in parallel to the substrate due to anisotropy relative to the crystal surface of the interface energy at the interface between the deposited material and the substrate, and when the substrate is amorphous, the crystal direction within the substrate plane is not constant. For this reason, grain boundaries are formed by the mutual collision between nuclei or islands, and particularly in the case of mutual collision between islands with some sizes or greater, grain boundaries are formed as such rather than occurrence of coalescence. Since the grain boundaries formed are difficult to move in the solid phase, the grain sizes are determined at that point.

Next, a selective deposition method for forming a deposited film selectively on the deposition surface is to be described. The selective deposition method is a method in which a thin film is formed selectively on a substrate by utilising differences between the materials in factors influencing nucleus formation in the thin film forming process such as surface energy, attachment coefficient, release coefficient, surface diffusion speed, etc.

Figs. 2A and 2B are illustrations of the selective deposition method. First, as shown in Fig. 2A, on the substrate 1, a thin film 2 comprising a material different in the above factors from the substrate 1 is formed at a desired portion. And, when deposition of a thin film comprising an appropriate material is effected under appropriate deposition conditions, a thin film 3 grows only on the thin film 2, whereby it is possible to give rise to a phenomenon that no growth occurs on the substrate 1. By utilising this phenomenon, the thin film 3 formed self-matchingly can be grown, whereby it becomes possible to omit the lithographic step using resist as practised in the prior art.

As the material for enabling deposition according to such selective formation method, for example, SiO₂ may be used as the substrate 1, Si, GaAs, silicon nitride as the thin film 2 and Si, W, GaAs, InP, etc., as the thin film 3 to be deposited.

Fig. 3 is a graph showing the change with lapse of time of nucleation density on the deposited surface of SiO₂ and the deposited surface of silicon nitride.

As shown in the same graph, soon after initiation deposition, the nucleation density on SiO₂ is saturated at 10³ cm⁻² or less, and the value is not substantially changed even after 20 minutes.

In contrast, on silicon nitride (Si₃N₄), it is once saturated at about 4 x 10⁵ cm⁻² or less, is not substantially changed 10 minutes thereafter, but is abruptly increased thereafter. This measurement example shows the case in which SiCl₄ gas is diluted with H₂ and deposited according to the CVD method under the conditions of a pressure of 2.27 x 10⁴ Pa (170 Torr) and a temperature of 1000°C. Otherwise, the same action can be obtained using SiH₄, SiH₂Cl₂, SiHCl₃, SiF₄, etc., as the reaction gas, and controlling the pressure, temperature, etc. Also, vacuum vapour deposition can be employed.

In this case, nucleation on SiO₂ poses substantially no problem, but by addition of HCl gas into the reaction gas, nucleation on SiO₂ can be further suppressed to make deposition of Si on SiO₂ perfectly zero.

Such a phenomenon depends greatly on the difference in adsorption coefficient, release coefficient, surface diffusion coefficient, etc., relative to Si of the material surfaces of SiO₂ and silicon nitride, but the fact that SiO₂ itself is etched by the reaction of SiO₂ with Si atom itself to form silicon monoxide with higher vapour pressure, while no such etching phenomenon occurs on silicon nitride may be also considered to be a cause to effect selective deposition (T. Yonehara, S. Yoshioka, S. Miyazawa, Journal of Applied Physics 53, 6839, 1982).

Thus, by selecting SiO₂ and silicon nitride as the materials of the deposition surface and silicon as the material to be deposited, sufficiently great nucleation density difference as shown in the same graph can be obtained. Here, although SiO₂ is desirable as the material for the deposition surface, this is not limitative and sufficiently practical nucleation density difference can be obtained even by use of SiOₓ (0 < x < 2).

Of course, the present invention is not limited to these materials, but the difference in nucleation density (AND) may be sufficiently 10³-fold or more in density of nuclei as shown by the same graph, and sufficient selective formation of deposited film can be done with the materials as exemplified below.

As another method for obtaining this nucleation density difference (ΔND), ions of Si or N may be injected locally into the SiO₂ surface to form a region having excessive Si or N.

The present invention utilises selective deposition based on such nucleation density difference (AND) and, by forming sufficiently finely so that a single nucleus may grow on the deposition surface of a different kind of material having sufficiently greater nucleation density than the material of the deposition surface, a single crystal can be grown selectively only at the site where such fine different kind of material exists.

In this connection, since selective growth of a single crystal is determined depending on the electron state of the deposition surface, particularly the state of dangling bonds, the material with lower nucleation density (for example, SiO₂) is not required to be a bulk material, but it may be formed only on the surface of any desired material, substrate, etc., to form the above deposited surface.

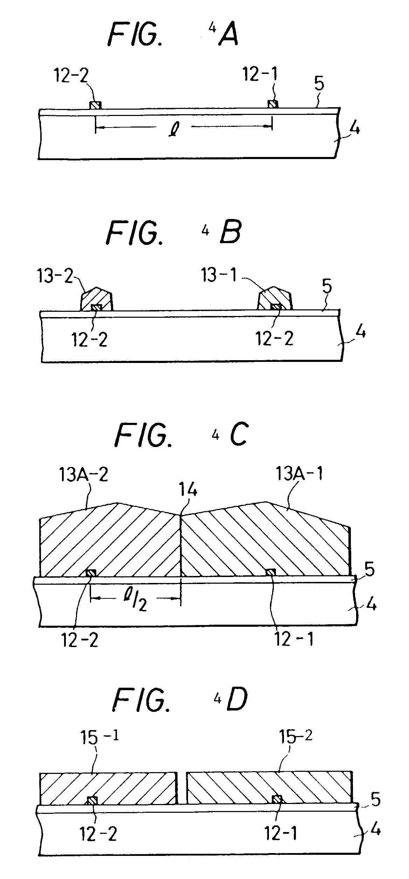

Figs. 4A to 4D are illustrations of the formation steps of a method for forming single crystal islets and Figs. 5A and 5B are perspective views of the substrate in Figs. 4A and 4D. First, as shown in Fig. 4A and Fig. 5A, on the substrate 4, a thin film 5 with small nucleation density which enables selective deposition is formed to provide an interlayer insulation layer and a material different from the material forming the thin film 5 with a greater nucleation density is deposited thinly, followed by patterning according to lithography, etc., to form sufficiently fine area nucleus forming regions 12-1, 12-2 comprising a different kind of material, spaced at intervals, "ℓ" apart. The substrate 4 has functional device elements formed thereon prepared according to conventional semiconductor technique. The nucleus forming regions 12-1, 12-2 may be formed by ion injection of Si or N into the thin film 5 instead of by deposition as described above.

Next, by selecting appropriate crystal forming conditions, only a single nucleus of a crystal forming material is formed on each of the nucleus forming surfaces 12-1, 12-2. That is, the nucleus forming surfaces 12-1, 12-2 are required to be formed to a sufficiently fine size (area) to the extent that only a single nucleus may be formed. The size of these surfaces 12-1, 12-2, may be different depending on the kind of the material, may be several µm or less. Further, each nucleus grows while maintaining a single crystal structure, and each grows to become a single crystal grain 13-1,13-2 as shown in Fig. 4B. For forming island-shaped single crystal grains 13-1, 13-2, it is desirable to determine the conditions so that no nucleation may occur at all on other surfaces 5 than the nucleus forming surfaces 12-1, 12-2 on the substrate 4.

The crystal direction in the normal line direction of the substrate 11 of the island-shaped single crystal grains 13-1, 13-2 is determined so as to make the interface energy of the material of the substrate 4 and the material forming the nuclei a minimum. For, surface or interface energy has anisotropy depending on the crystal face. However, as already mentioned, the crystal direction within the substrate plane on an amorphous surface is not determined.

The island-shaped single crystal grains 13-1, 13-2 further grow to become single crystals 13A-1, 13A-2 until the adjacent single crystals 13A-1, 13A-2 contact each other as shown in Fig. 4C, but since the crystal directions within the substrate plane are not constant, crystal grain boundaries 14 are formed at intermediate positions between the nucleus forming surfaces 12-1 and 12-2.

Subsequently, the single crystals 13A-1, 13A-2 grow three-dimensionally, but crystal faces with slow growth speed appear. For this reason, the surfaces of single crystal grains 13A-1, 13A-2 are flattened by etching or polishing, and further portions including the grain boundaries 14 are removed to form thin film single crystal islets 15-1, 15-2 containing no grain boundary. The size of the single crystal film islets 15-1, 15-2, 15 is determined by the interval ℓ between the nucleation surfaces (S_{NDL}) as described above. That is, by determining appropriately the formation pattern of the nucleus forming regions 12-1, 12-2 the positions of the grain boundaries can be controlled to form single crystal islets with desired sizes having a desired arrangement, e.g. a lattice array.

Various materials usable as nucleus forming region material will be discussed below.

### (Composition of silicon nitride)

For obtaining sufficient nucleation density difference (AND) between the material for formation of non-nucleation surface (interlayer insulation layer) and the material for formation of nucleation surface (nucleus forming region) as described above, for SiO₂ as the material for formation of non-nucleation surface to be used in combination, the material for formation of nucleation surface is not limited to Si₃N₄, but silicon nitrides with various chemical composition ratios may be employed.

The chemical composition ratio of silicon nitride may be varied as follows.

In the plasma CVD method for forming silicon nitride film at low temperature by decomposition of SiH₄ gas and NH₃ gas in RF plasma, by varying the flow rate ratio of SiH₄ gas and NH₃ gas, the composition ratio of Si and N in the deposited silicon nitride film can be varied to a great extent.

Fig. 6 is a graph showing an example of the relationship between the flow rate ratio of SiH₄ and NH₃ and the composition ratio of Si and N in the silicon nitride film formed.

The deposition conditions at this time were RF output of 175 W, substrate temperature of 380°C and the flow rate of NH₃ gas was varied with the SiH₄ gas flow rate being fixed at cc/min. As shown in the same graph, by varying the gas flow rate ratio of NH₃/SiH₄ from 4 to 10, the Si/N ratio in the silicon nitride film was found to be varied from 1.1 to 0.58 according to Auger's electron spectrophotometry.

On the other hand, the composition of the silicon nitride film formed according to the reduced pressure CVD method by introducing SiH₂Cl₂ gas and NH₃ gas under the conditions of a reduced pressure of 4.0 x 10 Pa (0.3 Torr) and a temperature of about 800°C was found to be Si₃N₄ (Si/N = 0.75) which is approximately the stoichiometric ratio.

Also, the silicon nitride film formed by heat treatment at about 1200°C in ammonia or N₂ (hot nitrification method) can be obtained with a composition further approximate to the stoichiometric ratio, since the formation method is performed under thermal equilibrium.

By use of silicon nitrides formed by the various methods as described above as the material for forming nucleation surface (S_{NDL}) with higher nucleation density than SiO₂, the above nucleus of Si can be grown on the nucleation surface (S_{NDL}) comprising silicon nitride to form Si single crystal based on the nucleation density (AND) corresponding to the chemical composition ratio of silicon nitride.

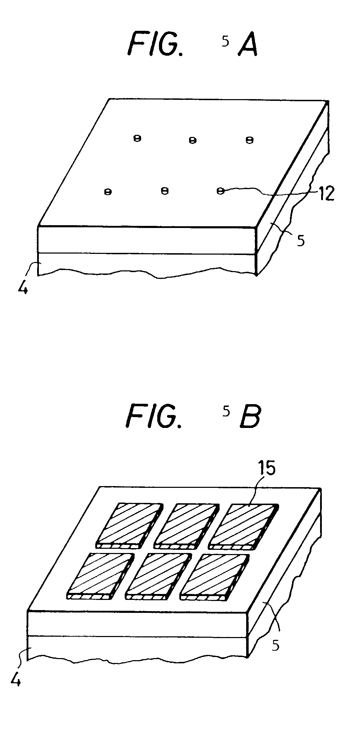

Fig. 7 is a graph showing the relationship between Si/N composition ratio and nucleation density (ΔND). As shown in the same graph, by varying the chemical composition ratio of the silicon nitride film, the nucleation density of the Si single crystal nucleus formed thereon changes to a great extent. The nucleation conditions in the graph shown in Fig.7 correspond to the case when Si single crystal nucleus was formed by reacting SiCl₄ gas reduced to 2.33x10⁴ Pa (175 Torr) with H₂ at 1000°C. Of course, another graph will be obtained if nucleation conditions such as gas species, pressure, temperature, etc., are changed.

The phenomenon that the nucleation density thus changes according to the chemical composition ratio of silicon nitride affects the size (area) of the nucleation surface (S_{NDL}) when employing silicon nitride as the material for forming the nucleation surface (S_{NDL}) which is formed sufficiently finely to the extent that a single nucleus may be grown. That is, when employing silicon nitride having a composition with great nucleation density (ND) only a single crystal can be formed on the nucleation surface (S_{NDL}) by forming the nucleation surface (S_{NDL}) extremely finely as compared with the silicon nitride with relatively smaller nucleation density (ND). Such a point is applicable as a similar tendency for other materials for forming nucleation surface (S_{NDL}). Accordingly, in the present invention, for accomplishing its objects effectively, it is desirable to select a nucleation density (ND) and a size of nucleation surface (S_{NDL}) formed of silicon nitride, etc., capable of forming only a single crystal suitably as desired. For example, under the nucleation condition for obtaining a nucleation density (ND) of about 10⁵ cm⁻² or less, it is possible to form selectively, only a single nucleus, if the size of the nucleation surface (S_{NDL}) comprising silicon nitride is about 4 µm or less. The Si/N ratio in that case is about 0.5.

### (Formation of nucleation surface (S_{NDL}) by ion injection)

As another method for realizing nucleation density difference when forming Si single crystal nucleus, ion injection of Si, N, P, B, F, Ar, He, C, As, Ga, Ge, etc., may be effected locally onto the surface comprising SiO₂ which is a material for forming nonnucleation surface (S_{NDS}) with smaller nucleation density to form a modified region with a desired size on the SiO₂ surface, and utilize this modified region as the nucleation surface (S_{NDL}) with greater nucleation density (ND).

For example, the SiO₂ layer surface is covered with a photoresist layer and the desired portions are exposed, developed and dissolved to have the SiO₂ layer surface exposed.

Subsequently, by use of SiF₄ gas as the source gas, Si ions are implanted onto the SiO₂ layer surface exposed at 10 keV at a density of 1 x 10¹⁶ ∼ 1 x 10¹⁸ cm⁻². The projected flying distance in this case is 11,4 nm (114 Å), and the Si concentration on the exposed surface of SiO₂ layer reaches about 10²² cm⁻³ or less. Since the SiO₂ layer is originally amorphous, the modified layer made excessively enriched in Si by injection of Si ions is also amorphous.

For formation of a modified region, ion injection can be effected with the use of a resist as the mask, but it is also possible to inject a narrowed Si ion beam selectively at a desired position on the SiO₂ layer surface within a desired area without use of a resist mark by use of converged ion beam technique.

After having thus effected Si ion injection, by peeling of the resist on the remaining portion, Si-excessive modified region is formed on the SiO₂ layer surface at a desired position with a desired size. On the modified region of the SiO₂ layer surface having such modified region formed, Si single crystal is permitted to grow in vapour phase.

Fig. 8 is a graph showing the relationship between amount of Si ions injected and nucleation density (ND).

As shown in the same graph, it can be understood that nucleation density (ND) is increased as the amount of Si⁺ injected is more.

Accordingly, by forming a modified region sufficiently finely, only a single nucleus of Si can be grown with the modified region being as the nucleation surface (S_{NDL}), whereby a single crystal can be grown as described above.

It can be easily accomplished by patterning of a resist or narrowing of beam of the converged ion beam to form sufficiently finely the modified region to the extent that only a single nucleus may grow.

### (Method for formation of Si single crystal nucleus other than CVD)

For growth of single crystal by selective nucleation of Si, not only the CVD method, but also the method by evaporation of Si into vacuum (10⁻⁴ Pa (10⁻⁶ Torr)) with an electron gun and deposition on a heated substrate may be used. Particularly, in the MBE (Molecular Beam Epitaxy) method which performs vapor deposition in ultra-high vacuum (< 10⁻⁷ Pa (10⁻⁹ Torr)), it has been known that Si beam begins to react with SiO₂ at a substrate temperature of 900°C or higher, whereby no nucleation of Si occurs on SiO₂ at all (T. Yonehara, S. Yoshioka and S. Miyazawa, Journal of Applied Physics 53, 10, p. 6839, 1983).

By utilizing this phenomenon, single crystal nuclei of Si can be formed with perfect selectivity on the fine silicon nitride regions permitted to exist in spots on the SiO₂ layer, and single crystal Si can be grown thereon. The single crystal growth conditions as preferable example at this time may be, for example, a vacuum degree of 10⁻⁶ Pa (10⁻⁸ Torr) or lower, Si beam intensity of 9.7 x l0¹⁴ atoms/cm²·sec, and a substrate temperature of 900°C ∼ 1000°C.

In this case, through the reaction SiO₂ + Si → 2SiO↑, a reaction product of SiO with a remarkably high vapour pressure is formed, and etching of SiO₂ itself with Si through this evaporation occurs.

In contrast, no such etching phenomenon as mentioned above occurs on silicon nitride, but nucleation of Si single crystal and growth of single crystal occur.

Accordingly, as the material for forming nucleation surface (S_{NDL}) with high nucleation density (ND), tantalum oxide (Ta₂O₅), silicon nitride oxide (SiON), etc., can be also used other than silicon nitride to obtain the same effect. That is, by forming the above nucleation surface (S_{NDL}) with these materials in fine areas, single crystals of Si can be permitted to grow similarly.

Fig. 9 is a sectional view showing an embodiment of the photoelectric conversion device according to the present invention. In the Figure, there are laid on a p-type silicon substrate 101, a first layer formed with bipolar transistors 102, a second layer formed with MOS transistors 103 and a third layer (top layer) formed with photodiodes 104.

The bipolar transistors 102 of the first layer are formed in the substrate 101 using a conventional integrated circuit manufacturing process. First, buried layers 105 are formed in the p-type substrate 101 by diffusing impurity such as As, Sb or P. There is formed on each buried layer 105 an n-epitaxial layer 106 serving as a collector region.

P-base regions 107 are formed in the n-epitaxial layer 106 by diffusing impurity such as boron. An n⁺-emitter region 108 is formed in each p-base region 107 by diffusing impurity such as P or As. After forming p-type element isolation regions 109 by impurity diffusion, the whole surface is covered with an insulation layer 110. Contact holes are made and emitter electrodes, base electrodes and collector electrodes are formed.

In this embodiment, the interlayer insulation layer 111 is formed using SiO₂ which is not only a material with a small nucleation density but also an insulation material. The interlayer insulation layer 111 is formed by the CVD method. It is preferable to make the surface even.

Next, there is formed on the interlayer insulation layer 111 nucleus forming regions 113 of minute area, using a material having a sufficient nucleation density higher than that of SiO₂. In this embodiment, silicon nitride is used as such a material to form p-type silicon monocrystalline islets 114 of 1.2 µm □ as described below, under a temperature of 700 to 1000°C which does not deteriorate the characteristics of the bipolar transistors in the first layer.

Next, after forming a gate insulation layer 115A on each p-type monocrystalline silicon islet 114, gate electrodes 115 are formed. Thereafter, source/drain regions are formed by n-type impurity diffusion and other necessary interconnections are formed, to thereby complete the second layer having n-channel MOS transistors.

Contact holes are opened in the interlayer insulation layer 111 to connect the MOS transistors 103 to the bipolar transistors 102 by interconnections 112.

Next, an interlayer insulation layer 116 is formed on the second layer. N-type monocrystalline silicon islets 119 are then formed by selective nucleus forming crystal growth, using nucleus forming regions 118 of fine area made of the above-described material. Succeedingly, a p-region 120 is formed in each monocrystalline silicon islet 119 by p-type impurity diffusion, to thereby form pn junction photodiodes 104. Contact holes are opened in the interlayer insulation layer 116 and the photodiodes 104 are connected to the MOS transistors in the lower layer by interconnections 117.

By forming a plurality of photodiodes 104 in the top layer, a photoelectric conversion device of good sensitivity can be realised because incident light can be applied efficiently to the photodiodes 104.

Since the monocrystalline silicon islets can be formed at a low temperature in the order of 700 to 1000°C, elements in the lower layer are not deteriorated in their characteristics. The mobility in the channel of each MOS transistor 103 is larger than 400 cm²/V sec which is more than ten times that of a conventional MOS transistor formed in a polysilicon layer.

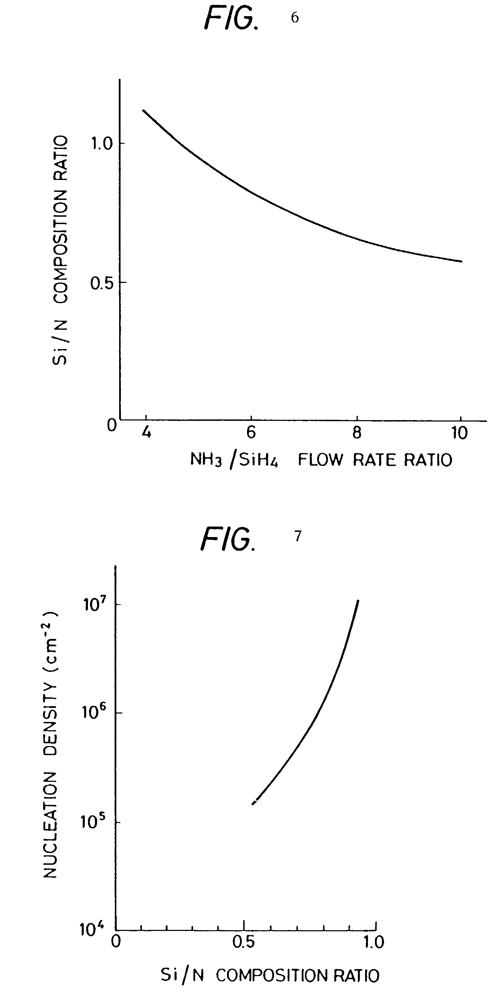

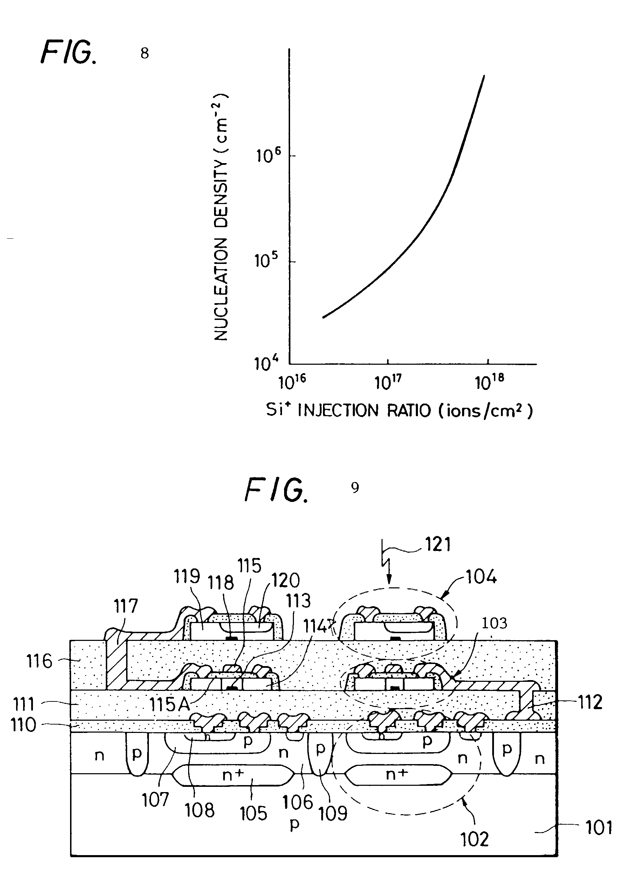

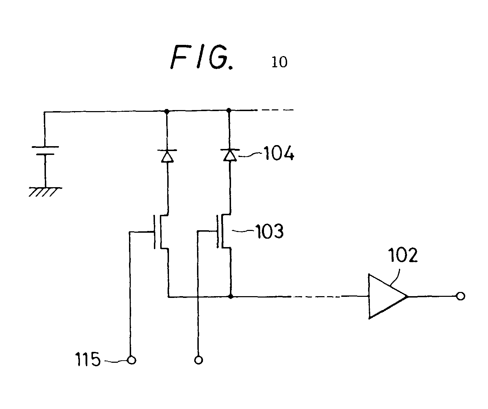

Fig. 10 is an example of a typical circuit that may be employed in the embodiment shown in Fig. 9. In the Figure, photodiodes 104 are arranged in an array, one ends of which are applied with a source voltage and the other ends of which are coupled via MOS transistors 103 to an amplifier 102 made of bipolar transistors. Outputs of the photodiodes 104 are scanned in response to control signals applied to the gate electrodes 115 of the MOS transistors 103, and serially sent to the amplifier 102.

In the above embodiment, since outputs from the photodiodes 104 are processed by high performance MOS transistors 103 and bipolar transistors 102 in monocrystalline, a high speed operation is possible.

A three-layered structure has been employed in the above embodiment. Further layers may be included, in particular the circuit section may be formed in a multi-layered structure. Thus, for instance, a signal read section, a calculation section, a memory section and the like may be formed separately in different layers.

Further, a photodiode has been used as a photosensor. Obviously, other types of photosensor such as a phototransistor, may be used.

As described so far, the photoelectric conversion device of this embodiment improves an aperture ratio and attains a high sensitivity. Further, by using the above-described method of forming a crystal layer, monocrystals can be grown easily even on a substrate made of amorphous material. Thus, a high performance photosensor, field effect transistor, bipolar transistor and the like can be formed as a multi-layered integrated circuit structure. As a result, a photoelectric conversion device can be realised which operates at high speed and has various functions.

## Claims

1. A method of producing a multilayer photoelectric conversion device, which method comprises the following steps:
(a) providing a semiconductor substrate (101) and producing at the main surface of said substrate (101) a plurality of bipolar transistors (102);
(b) covering said plurality of bipolar transistors (102) with an interlayer insulation layer (111);
(c) establishing at the surface of said interlayer insulation layer (111) a plurality of nucleus forming regions (113) having the property of nucleating a semiconductor material at a higher nucleation density than that of the adjacent surface of said interlayer insulation layer (111), each of said nucleus forming regions (113) being limited in size so that during an initial stage of deposition each shall support the formation of a single nucleus only of the semiconductor material;
(d) depositing the semiconductor material and forming a single nucleus thereof on each nucleus forming region (113);
(e) upon further deposition of the semiconductor material, epitaxially growing single crystal semiconductor material from each single nucleus and producing respective single crystal islets (114);
(f) producing at the surface of each islet (114) a field effect transistor (103);
(g) opening contact holes in the interlayer insulation layer and connecting the plurality of bipolar transistors (102) to the plurality of field effect transistors (103);
(h) covering said plurality of field effect transistors (103) with an interlayer insulation layer (116);
(i) repeating steps (c) to (e) aforesaid;
(j) producing at the surface of each islet (119) a photosensor (104); and
(k) opening contact holes in the latter interlayer insulation layer (116) and connecting the plurality of field effect transistors (103) to the plurality of photosensors (104).

2. A method as claimed in claim 1 wherein:
each photosensor (104) is a photodiode.

3. A method as claimed in either preceding claim wherein:
the semiconductor material is silicon,
each interlayer insulation layer (111, 116) is of silicon oxide SiO₂; and
the nucleus forming regions (113,118) are of silicon nitride.

## Patentansprüche

1. Verfahren zur Herstellung eines mehrschichtigen photoelektrischen Wandlers, wobei das Verfahren die nachstehenden Schritte umfaßt:
(a) Bereitstellung eines Halbleitersubstrats (101) und Herstellung einer Vielzahl bipolarer Transistoren (102) auf der Hauptfläche des Substrats (101);
(b) Bedecken der Vielzahl bipolarer Transistoren (102) mit einer isolierenden Zwischenschicht (111);
(c) Bildung einer Vielzahl kristallkeimbildender Bereiche (113) auf der Oberfläche der isolierenden Zwischenschicht (111), die die Eigenschaft aufweisen, mit einer höheren Dichte der Kristallkeimbildung als diejenige der angrenzenden Fläche der isolierenden Zwischenschicht (111) Kristallkeime des Halbleitermaterials zu bilden, wobei jeder der kristallkeimbildenden Bereiche (113) so in seiner Größe beschränkt ist, daß während der Anfangsstufe der Abscheidung jeder die Bildung nur eines einzelnen Kristallkeims aus dem Halbleitermaterial fördert;
(d) Abscheidung des Halbleitermaterials und Bildung eines einzelnen Kristallkeims daraus auf jedem kristallkeimbildenden Bereich (113);
(e) bei weiterer Abscheidung des Halbleitermaterials ein epitaxiales Aufwachsen eines einkristallines Halbleitermaterials auf jeden einzelnen Kristallkeim und Herstellung entsprechender einkristalliner Inseln (114);
(f) Herstellung eines Feldeffekttransistors (103) auf der Fläche einer jeden Insel (114);
(g) Bildung von Kontaktlöchern in der isolierenden Zwischenschicht und Verbinden der Vielzahl der bipolaren Transistoren (102) mit der Vielzahl der Feldeffekttransistoren (103);
(h) Bedecken der Vielzahl der Feldeffekttransistoren (103) mit einer isolierenden Zwischenschicht (116);
(i) Wiederholen der vorstehenden Schritte (c) bis (e);
(j) Herstellung eines Photosensors (104) auf der Fläche einer jeden Insel (119); und
(k) Bildung von Kontaktlöchern in der letztgenannten isolierenden Zwischenschicht (116) und Verbinden der Vielzahl der Feldeffekttransistoren (103) mit der Vielzahl der Photosensoren (104).

2. Verfahren nach Anspruch 1, in dem jeder Photosensor (104) eine Photodiode ist.

3. Verfahren nach einem der vorstehenden Ansprüche, in dem das Halbleitermaterial Silicium ist,
jede isolierende Zwischenschicht (111, 116) aus Siliciumdioxid SiO₂ besteht; und
die kristallkeimbildenden Bereiche (113, 118) aus Siliciumnitrid bestehen.

## Revendications

1. Procédé de production d'un dispositif de conversion photo-électrique multicouche, lequel procédé comprend les étapes suivantes dans lesquelles :
(a) on se procure un substrat semiconducteur (101) et on produit, à la surface principale dudit substrat (101), une pluralité de transistors bipolaires (102) ;
(b) on recouvre ladite pluralité de transistors bipolaires (102) d'une couche d'isolation intercouche (111) ;
(c) on établit à la surface de ladite couche d'isolation intercouche (111) une pluralité de régions (113) de formation de germes ayant la propriété de former par germination une matière semiconductrice à une densité de germination supérieure à celle de la surface adjacente de ladite couche d'isolation intercouche (111), chacune desdites régions (113) de formation de germes ayant une dimension limitée afin que, pendant une étape initiale de déposition, chacune d'elles supporte la formation d'un seul germe de la matière semiconductrice ;
(d) on dépose la matière semiconductrice et on en forme un germe unique sur chaque région (113) de formation de germes ;
(e) en poursuivant la déposition de la matière conductrice, on procède à une croissance épitaxiale d'une matière semiconductrice monocristalline à partir de chaque germe unique et on produit des îlots respectifs (114) de monocristal ;
(f) on produit à la surface de chaque îlot (114) un transistor (103) à effet de champ ;
(g) on ouvre des trous de contact dans la couche d'isolation intercouche et on connecte la pluralité de transistors bipolaires (102) à la pluralité de transistors (103) à effet de champ ;
(h) on recouvre ladite pluralité de transistors (103) à effet de champ d'une couche d'isolation intercouche (116) ;
(i) on répète les étapes (c) à (e) précitées ;
(j) on produit à la surface de chaque îlot (119) un photocapteur (104) ; et
(k) on ouvre des trous de contact dans la dernière couche d'isolation intercouche (116) et on connecte la pluralité de transistors (103) à effet de champ à la pluralité de photocapteurs (104).

2. Procédé selon la revendication 1, dans lequel :
chaque photocapteur (104) est une photodiode.

3. Procédé selon l'une quelconque des revendications précédentes, dans lequel :
la matière semiconductrice est du silicium,
chaque couche d'isolation intercouche (111, 116) est en oxyde de silicium SiO₂, et
les régions (113, 118) de formation de germes sont en nitrure de silicium.
